# EUROPÄISCHE PATENTSCHRIFT

(11) **EP 2 287 925 B1**
(45) Veröffentlichungstag und Bekanntmachung des Hinweises auf die Patenterteilung: **06.06.2018**
(21) Anmeldenummer: 10177644.1
(22) Anmeldetag: 18.01.1999
(51) Int. Cl.: H01L 25/075, H01L 33/56, H01L 33/48, H01L 33/50, H01L 33/64, F21Y 115/10

(54) **Ausdehnungskompensiertes optoelektronisches Halbleiter-Bauelement, insbesondere UV-emittierende Leuchtdiode**
Expansion compensated optoelectronic semiconductor device, in particular UV emitting diode
Dispositif semiconducteur optoélectronique compensé pour la dilatation, en particulier diode émettant dans l'UV

(30) Priorität: 30.01.1998 DE 19803936
(43) Veröffentlichungstag der Anmeldung: 23.02.2011
(62) Teilanmeldung aus: 99100385.6
(73) Patentinhaber: OSRAM Opto Semiconductors GmbH, 93055 Regensburg (DE); OSRAM GmbH, 80807 München (DE)
(72) Erfinder: Waitl, Günter, 93049 Regensburg (DE); Langer, Alfred, 86438 Kissing (DE); Weitzel, Reinhard, 82216 Gerlinden (DE)
(74) Vertreter: Epping - Hermann - Fischer

(56) Entgegenhaltungen:
- WO-A1-97/48134
- DE-A1- 19 625 622
- DE-C1- 19 508 222
- DE-C1- 19 641 980
- JP-A- 8 007 614
- JP-U- H0 641 017
- US-A- 5 264 393
- US-A- 5 384 519
- "LEUCHTET IN VERSCHIEDENEN FARBEN", ELEKTRONIK, IRL PRESS LIMITED, DE, Bd. 44, Nr. 15, 25. Juli 1995 (1995-07-25) , Seite 134, XP000523322, ISSN: 0013-5658

## Beschreibung

### Technisches Gebiet

Die Erfindung betrifft ein ausdehnungskompensiertes optoelektronisches Modul gemäß Anspruch 1. Es handelt sich dabei um ein Modul mit einer Leuchtdiode, die im Bereich von 320 bis 400 nm emittiert, mit Lumineszenzkonversion in weißes Licht.

Deren Einsatzgebiet ist hauptsächlich die Allgemeinbeleuchtung. Als Halbleiter wird meist ein Nitrid des Galliums und/oder Indiums und/oder Aluminiums verwendet.

### Stand der Technik

Ein optoelektronisches Halbleiter-Bauelement wie beispielsweise eine Leuchtdiode ist in seiner Anwendungsmöglichkeit eingeschränkt, ohne dass dieser Mangel von der Fachwelt bisher so empfunden wird. Scheinbar ist Kunststoff ideal als Gehäusewerkstoff geeignet, da er leicht verarbeitet werden kann. Weitverbreitet ist die Gießharztechnologie mit Epoxid. Die scheinbar ideale Eignung des Kunststoffs als Gehäusewerkstoff verdeckte bisher den Mangel einer fehlenden Abstimmung seines Ausdehnungsverhaltens bei Temperaturwechselbelastung. Durch die derzeit übliche Verwendung eines Kunststoffgehäuses ist die Arbeitstemperatur auf den Bereich von -55 °C bis +110 °C eingeschränkt. Außerdem scheiterte ein Einsatz bei sehr kurzen Wellenlängen (im UV-Bereich) bisher an der starken Degradation des Gehäuses.

Für die Erzeugung weißen Lichts für Zwecke der Allgemeinbeleuchtung kommen neuerdings weißes Licht emittierende Leuchtdioden in Frage. Sie basieren auf der Erzeugung des weißen Lichts mittels einer blau oder auch UV-emittierenden Leuchtdiode. Übliche Konzepte zur Realisierung basieren auf radialen Bauformen, die für die Durchsteckmontage (beispielsweise so genanntes LUCOLED-Design) geeignet sind, oder SMT-geeigneten Bauformen, dem so genannten Topled-Design für die Oberflächenmontage (SMT-LED). Genaueres hierzu findet sich beispielsweise in dem Artikel "White-light diodes are set to tumble in price" von Philip Hill, OLE Oktober 1997, Seite 17 bis 20. Beim LUCOLED-Konzept wird beispielsweise von einem blauen Emitter auf Basis GaN mittels Lumineszenzkonversion weißes Licht erzeugt.

In dem Artikel "High Power UV InGaN/AlGaN Double Heterostructure LEDs" von Mukai, Morita und Nakamura (Proceedings of the Second International Conference On Nitride Semiconductors, Seite 516, 1997, in Tokushima (Japan)), ist der Aufbau einer UV-emittierenden Leuchtdiode mit einer Emissionswellenlänge von etwa 370 nm beschrieben. Die Leuchtdiode weist einen Chip auf, der auf einem Leiterrahmen montiert ist und in einem Kunststoffgehäuse eingegossen wird.

In dem Artikel "Reliability Behavior of GaN-based Light Emitting Diodes" von D. Steigerwald (Proceedings of the Second International Conference On Nitride Semiconductors, Seite 514 bis 515, 1997, in Tokushima (Japan)), werden Leuchtdioden verschiedener Farbe untersucht. Es wurde festgestellt, dass die Degradation der Leuchtdiode mit kürzerer Emissionswellenlänge bis herab zu 470 nm stark zunimmt. Entscheidenden Anteil an der Degradation haben die Faktoren Betriebsstrom und Umgebungstemperatur sowie das Gehäuse aus Kunststoff. Zur Untersuchung wurde das Epoxidharz-Gehäuse vorübergehend entfernt.

Insgesamt erscheint daher der Betrieb einer UV-emittierenden Leuchtdiode bisher wenig Erfolg versprechend, da die UV-Strahlung das Gehäuse schädigt. Bei Verwendung einer blau emittierenden Leuchtdiode als Lichtquelle ist jedoch andererseits die Lichtausbeute und Effizienz relativ niedrig (zirka 5 lm/W).

Frühere optoelektronische Halbleiter-Bauelemente hatten als Gehäuse ein Metall-Glas-System, wobei in einer Metallkappe eine Glaslinse eingepasst wurde (siehe PCT-A PCT/DE96/01728). Damit konnte zwar höheren Anforderungen an die optischen Eigenschaften entsprochen werden, aber die Herstellkosten für die bodenplatte und die Linsenkappe sind unverhältnismäßig hoch, die Fertigung ist sehr aufwändig und die hohen Toleranzen in Fertigung und Justierung erlauben nur bedingt den Einsatz dieser Technologie. Die optische Perfektion des Systems ist daher für viele Applikationen nicht ausreichend.

Die Druckschrift WO 97/48134 A1 betrifft eine Beleuchtungseinrichtung mit mehreren LEDs.

Aus der Druckschrift "Leuchtet in verschiedenen Farben" in ELEKTRONIK, IRL PRESS LIMITED, DE, Bd. 44, Nr. 15, 25. Juli 1995, Seite 134, ISSN 0013-5658, ist eine RGB-Leuchte mit LEDs bekannt.

In der Druckschrift DE 196 41 980 C1 ist eine Weißlichtquelle auf der Basis von LED-Chips beschrieben.

Ein optoelektronischer Wandler mit einem Glas-Silizium-Gehäuse findet sich in der Druckschrift DE 195 08 222 C1.

Das Mischen von Farben und eine Lichtquelle für Licht verschiedener Farben ist in der Druckschrift US 5,384,519 A angegeben.

Gemäß der Druckschrift US 5,264,393 A weist eine Festkörperlichtquelle ein Gehäuse mit Materialien mit angepassten thermischen Ausdehnungskoeffizienten auf. Die Druckschrift DE 196 25 622 A1 offenbart ein Lichtabstrahlendes Halbleiterbauelement mit einem Strahlung aussendenden Halbleiterkörper mit mindestens zwei elektrischen Anschlüsse und mit einem Lumineszenzkonversionselement. Die Strahlung ist z. B. ultraviolett, blau oder grün. Mit dem Halbleiterbauelement kann mischfarbiges Licht, insbesondere weisses Licht erzeugt werden. Die Druckschrift JP H06-041017 U ist auf ein Display mit LEDs gerichtet.

### Darstellung der Erfindung

Es ist Aufgabe der vorliegenden Erfindung, ein optoelektronisches Modul bereitzustellen, das sich für einen erweiterten Einsatzbereich hinsichtlich Temperatur und Umgebungsfeuchtigkeit eignet.

Diese Aufgabe wird durch das Modul des Anspruchs 1 gelöst.

Im Einzelnen handelt es sich bei der vorliegenden Erfindung um ein Modul, bei dem ein strahlungsemittierender Halbleiterkörper auf einem elektrisch leitenden Leiterrahmen befestigt ist und von einem gasdichten Gehäuse umgeben ist. Alle eingesetzten Gehäusematerialien und der Leiterrahmen weisen im Temperaturbereich, der in Herstellung und Anwendung auftritt, aneinander angepasste thermische Ausdehnungskoeffizienten auf.

Es hat das Gehäuse einen Grundkörper mit einer Ausnehmung, wobei der Grundkörper an dem Leiterrahmen gasdicht befestigt ist. Der Halbleiter-Chip ist in der Ausnehmung auf dem Leiterrahmen befestigt. Die Ausnehmung ist mit einer separaten Abdeckung gasdicht verschlossen.

Der Grundkörper und die Abdeckung sind aus Glas oder Quarzglas oder Keramik oder Glaskeramik gefertigt. Die einzelnen Materialien sind im Temperaturbereich von -60 °C bis 150 °C optimal aufeinander abgestimmt. Damit lässt sich die Junctiontemperatur T_{J} von derzeit 100 °C auf 130 °C und mehr erhöhen. Dadurch sind LEDs im Außenbereich bis zu einer Umgebungstemperatur von etwa 100 °C einsetzbar, sodass sie sich für Automobilanwendungen oder Outdoor-Informationssysteme eignen.

Das erfindungsgemäße Modul besitzt den Vorteil, dass konventionelle Methoden der Befestigung unter Hochtemperaturbedingungen für den Halbleiterchip auf dem Leiterrahmen angewendet werden können. Bei den derzeit verwendeten Kunststoffgehäusen ist dies aufgrund der Temperaturempfindlichkeit von Kunststoff nicht möglich. Stattdessen werden hier Leitkleber, die beispielsweise Ag enthalten, verwendet.

Ein weiterer Vorteil des erfindungsgemäßen Moduls besteht darin, dass eine höhere Stabilität erzielt wird, weil Grenzschichteffekte zwischen Halbleiterchip und Kunststoffumhüllung ausgeschlossen sind. Weder im Langzeitbetrieb noch beim Löten tritt Delamination auf, sodass die Lichtauskopplung stabilisiert ist.

Ein besonderer Vorteil der vorliegenden Erfindung besteht darin, dass damit erstmals grundsätzlich die Möglichkeit geboten wird, eine UV-emittierende Leuchtdiode bereitzustellen, die eine hohe Lichtausbeute und Effizienz besitzt und die sich preisgünstig herstellen lässt. Diese liegt nicht nur an der grundsätzlichen fertigungsfreundlichen Konzeption, sondern auch daran, dass unter den jetzt zum Einsatz kommenden Materialien sich auch solche mit hoher Transparenz im UV und Beständigkeit gegen UV-Strahlung befinden, beispielsweise Quarzglas. Für Kunststoffe ist diese Anforderung praktisch nicht zu erfüllen.

Des Weiteren tritt keine mechanische Zug- und Druckbeanspruchung des Halbleiterchips auf. Folglich gibt es keine stressinjizierte Degradation.

Die heute bei Kunststoff auftretende Vergilbung durch Temperatur und UV-Einwirkung, die eine Verringerung der Lichtleistung im sichtbaren Spektrum zur Folge hat, tritt bei dem erfindungsgemäßen Modul nicht auf.

Der Leiterrahmen besteht aus an sich bekanntem Kupfer-Manteldraht. Unter Kupfer-Manteldraht wird ein Draht verstanden, dessen Seele aus einer Ni-Fe-Legierung und dessen Mantel aus Kupfer besteht.

Es ist das Gehäuse mehrteilig aus Einzelteilen zusammengesetzt, wobei die Einzelteile gasdicht miteinander verbunden sind, insbesondere durch direkte Verschmelzung oder durch Klebemittel. Dabei eignen sich besonders organische oder anorganische Kleber, beispielsweise Wasserglas.

Die Abdeckung auf dem Rahmenteil sitzt beispielsweise großflächig über der Oberfläche des Rahmens einschließlich der Ausnehmung oder ist nur im Bereich der Ausnehmung positioniert.

Vorteilhaft wird als Material für das Gehäuse niedrigschmelzendes Glas verwendet, vorteilhaft Weichglas, insbesondere Bleiglas oder Alkaliglas. Es ist typisch ab 400 °C verarbeitbar. Der thermische Ausdehnungskoeffizient liegt etwa bei 8 bis 11 x 10⁻⁶/K.

Die Differenz zwischen den thermischen Ausdehnungskoeffizienten einzelner Teile des Gehäuses ist nicht größer als +/- 15 %. In diesem Sinne sind obige Komponenten gut aufeinander abgestimmt, wenn beispielsweise als Leiterrahmen beziehungsweise Metalldurchführung eine Einschmelzlegierung des Typs VACOVIT oder VACON oder VACODIL verwendet wird. Diese enthalten Ni, Fe als Hauptbestandteile der Legierung, denen Cr oder Co zugesetzt sein kann (auch für Keramik geeignet).

Die Herstellung des erfindungsgemäßen Moduls kann auf verschiedene Weise erfolgen. Ein vorgestanztes Leiterband kann mit Pressglasteilen oder Sinterglasteilen beaufschlagt werden, die dann miteinander verklebt werden. Oder es werden von einem Glasrohling (Stab) Einzelstücke abgeschnitten, mit dem Leiterrahmen in Kontakt gebracht, erhitzt und formgepresst. Auf diese Weise wird der Leiterrahmen direkt in das Gehäuse eingebettet und die Einzelteile des Gehäuses werden miteinander verschmolzen.

Ein Sockel/Kappen-Aufbau kann einstückig realisiert werden. Oft ist es aber fertigungsfreundlicher, diesen Aufbau zweistückig zu realisieren, wobei auch hier ein Verschmelzen oder Verkleben (beispielsweise Silikonkleber) in Frage kommt.

Das erfindungsgemäße Konzept eignet sich hervorragend zur Schaffung einer auf LED basierenden Lampe oder Leuchte als Glühlampenersatz. Dabei ist insbesondere an eine Flächenleuchte gedacht, die aus mehreren LEDs als Einzelpixel eines Arrays aus mehreren Reihen und Spalten zusammengesetzt ist. Vorteilhaft werden die Einzelpixel gesondert elektronisch angesteuert.

Dabei kann die Flächenleuchte nicht nur als Lichtquelle, sondern auch teilweise (beispielsweise eine Reihe des Arrays) oder ganz als Informationsmedium eingesetzt werden, indem LEDs ein Piktogramm oder ähnliches formieren. Eine andere Realisierung ist eine kugelförmige Lampe, die innen einen Zuleitungsstab besitzt, wobei mehrere Einzelpixel um den Stab herum gruppiert sind.

Für den Einsatz für Allgemeinbeleuchtungszwecke kann eine Flächenlampe so hergestellt werden, dass eine Anzahl Grundelemente (Einzelpixel), die zu einer Lampe zusammengefasst werden, vollkonfektioniert oder teilkonfektioniert ohne Abdeckung beziehungsweise ohne Linse auf ein ebenes Substrat (Träger) aufgebracht und verschaltet werden. Sie werden von einem gemeinsamen äußeren Gehäuse umgeben. Eine etwaige Lumineszenzkonversion kann hier durch eine gemeinsame Abdeckung realisiert werden. Hierdurch kann eine extrem flache Bauweise erzielt werden. Die Fläche des Trägers kann auch beliebig geformt sein, beispielsweise als Kugel oder Rundstab (siehe oben). Da das Basiselement ein Halbleiter-Bauteil ist, kann die benötigte Ansteuerelektronik auf dem gleichen Substrat integriert werden, beispielsweise mittels Siebdruck oder SMT. Auch Dimmung ist über einen weiten Bereich möglich. Flächenhafte Lampen können durch direkte Chipmontage in erfindungsgemäß hergestellten Multichip-Gehäusen hergestellt werden. Dabei sind auch Module möglich, die weißes Licht durch drei Einzelkomponenten (Rot, Grün, Blau) erzeugen. Schließlich ist hiermit auch eine gezielte stufenlos regelbare Einstellung der Farbtemperatur möglich. Als Beispiel wird auf eine Grundbaueinheit mit weißem Licht verwiesen, der weiter einzelne Komponenten, die rote oder blaue Anteile zur Senkung oder Erhöhung der Farbtemperatur beitragen, zugemischt werden.

Weiterhin werden die folgenden Aspekte der Erfindung in einer nummerierten Reihenfolge angegeben:
1. Modul, bei dem strahlungsemittierender oder - empfangender Halbleiterkörper auf einem elektrisch leitenden Leiterrahmen befestigt ist und von einem Gehäuse umgeben ist, wobei alle eingesetzten Gehäusematerialien und der Leiterrahmen im Temperaturbereich, der in Herstellung und Anwendung auftritt, aneinander angepasste thermische Ausdehnungskoeffizienten aufweisen.
2. Modul nach Aspekt 1, wobei der Leiterrahmen aus Kupfer-Manteldraht oder ähnlichem besteht.
3. Modul nach Aspekt 1, wobei das Gehäuse mehrteilig aus Einzelteilen zusammengesetzt ist, wobei die Einzelteile gasdicht miteinander, insbesondere durch Klebemittel, verbunden sind.
4. Modul nach Aspekt 1, wobei das Gehäuse einen Grundkörper (Bodenteil) mit einer Ausnehmung aufweist, wobei der Grundkörper an dem Leiterrahmen gasdicht befestigt ist, der Halbleiter-Chip in der Ausnehmung auf dem Leiterrahmen befestigt ist, und die Ausnehmung mit einer Abdeckung gasdicht verschlossen ist.
5. Modul nach Aspekt 4, wobei der Grundkörper und/oder die Abdeckung aus Glas oder Quarzglas oder Keramik oder Glaskeramik gefertigt ist.
6. Modul nach Aspekt 1, wobei das Gehäuse ein Bodenteil und ein Rahmenteil, das den Halbleiter-Chip umgibt, aufweist, wobei der Leiterrahmen zwischen dem Bodenteil und dem Rahmenteil angeordnet ist und wobei alle diese Komponenten untereinander gasdicht verbunden sind.
7. Modul nach Aspekt 6, wobei eine Abdeckung auf dem Rahmenteil sitzt.
8. Modul nach Aspekt 4 oder 7, wobei die Abdeckung optische Eigenschaften besitzt, insbesondere eine Fresneloptik, eine bifokale Linse, eine plankonvexe oder plankonkave Linse aufweist.
9. Modul nach Aspekt 6, wobei die Innenseite des Rahmenteils und/oder die Innenseite des Bodenteils eine Reflexionsschicht aufweist, insbesondere eine metallische oder oxidische Schicht, wie TiO₂, Ag oder Al oder Au.
10. Modul nach Aspekt 4, wobei der Grundkörper einstückig als Pressglaskörper ausgebildet ist, wobei der Leiterrahmen in den Grundkörper eingebettet ist.
11. Modul nach Aspekt 1, wobei das Gehäuse eine Kappe und ein Bodenteil mit einen Sockel und mit mindestens zwei elektrisch und thermisch leitenden Metalldurchführungen aufweist, der Halbleiter-Chip auf einer der Metalldurchführungen aufgebracht ist, und die Kappe auf den Sockel aufgesetzt und mit diesem gasdicht verbunden ist, wobei zumindest der Sockel und die Kappe aus Glas oder Quarzglas oder Keramik oder Glaskeramik gefertigt sind.
12. Modul nach Aspekt 11, wobei die Kappe ein Lichtaustrittsfenster besitzt, die ein optisches Element, insbesondere eine Linse oder einen Filter, aufweist.
13. Modul nach Aspekt 1, wobei der Halbleiter-Chip UV-Strahlung, insbesondere im Bereich 320 bis 400 nm, emittiert.

### Figuren

Im Folgenden soll die Erfindung anhand von Ausführungsbeispielen und nicht erfindungsgemäßen Abwandlungen näher erläutert werden. Es zeigen:
- Figur 1: eine Abwandlung eines Halbleiter-Bauelements im Schnitt,
- Figur 2: eine weitere Abwandlung eines Halbleiter-Bauelements in perspektivischer Explosionsdarstellung,
- Figur 3: ein Ausführungsbeispiel einer Flächenleuchte,
- Figur 4: eine Abwandlung einer Lampe.

### Beschreibung der Zeichnungen

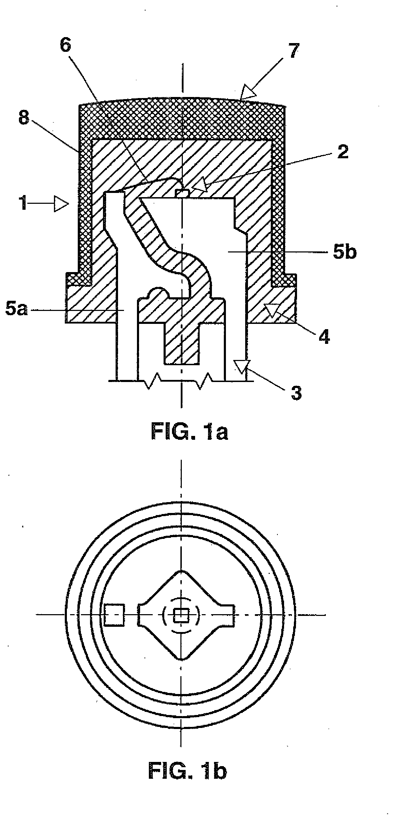

In Figur 1 ist eine nicht erfindungsgemäße Leuchtdiode 1 gezeigt in Schnitt (Figur 1A) und Draufsicht (Figur 1B). Sie weist einen Halbleiterchip 2 auf, der auf einem Leiterrahmen 3 befestigt ist. Der Chip 2 ist elektrisch leitend mit zwei durch ein Bodenteil 4 hindurchgeführten Elektrodenanschlüssen 5, die Bestandteile des Leiterrahmens sind, verbunden. Ein Kontaktdraht 6 bewirkt die Verbindung des Chips 2 mit dem einen Elektrodenanschluss 5a, während die elektrische Verbindung mit dem anderen Elektrodenanschluss 5b durch Bondverbindung der elektrisch leitenden Unterseite des Chips mit der Trägerfläche, die einstückig mit dem Elektrodenanschluss 5b ausgebildet ist, bewerkstelligt wird. Die zur optischen Abbildung des Chips vorgesehene Linse 7 ist als oberes Abschlussteil einer hohlzylindrischen Kappe 8 ausgebildet. Die Kappe 8 umgibt einen wesentlichen Teil des Bodenteils 4.

Das Bodenteil wie auch die Kappe sind beispielsweise aus Bleiglas der folgenden Zusammensetzung hergestellte: SiO₂ 60-65 Gew-%; PbO 20-22 Gew-%; K₂O 4-10 Gew-%; Na₂O 4-7 Gew-%. Ein anderes Bleiglas hat die Zusammensetzung SiO₂ 46-50 Gew-%; PbO 37-42 Gew-%; K₂O 0,5-5 Gew-%; Na₂O 7-13 Gew-%; Al₂O₃ 0-2 Gew-%.

Es eignen sich auch bleifreie Gläser als Ersatz für Bleiglas, wie sie beispielsweise in US 5,391,523, EP-A 734051, EP-A 603933 und DE-A 19547567 beschrieben sind. Dort sind auch weitere geeignete Durchführungen beschrieben.

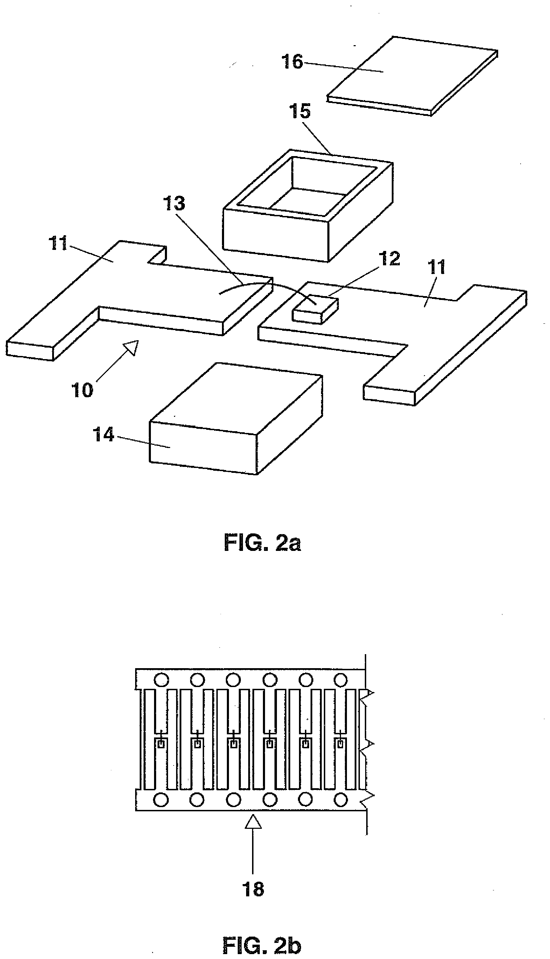

Figur 2A zeigt eine nicht erfindungsgemäße Abwandlung einer Leuchtdiode in Topled-Ausführung. Der Leiterrahmen 10 besteht aus zwei metallischen Bändern 11, von denen eines in an sich bekannter Weise mit dem Chip 12 bestückt ist. Ein Kontaktdraht 13 verbindet den Chip 12 mit dem zweiten Band. Das Gehäuse besteht hier aus einem quaderförmigen Bodenteil 14, das von unten an den Leiterrahmen 10 geklebt wird. Ein rechteckiges Rahmenteil 15 wird von oben auf den Leiterrahmen 10 befestigt. Zusätzlich wird eine Abdeckung 16 benötigt, die das Rahmenteil nach oben abschließt und vorteilhaft optische Eigenschaften besitzt. In Figur 2B ist ein Chipträgerband 18, bestehend aus einer Vielzahl von miteinander verbundenen Leiterrahmen zur Herstellung eines optoelektronischen Halbleiter-Bauelements gezeigt.

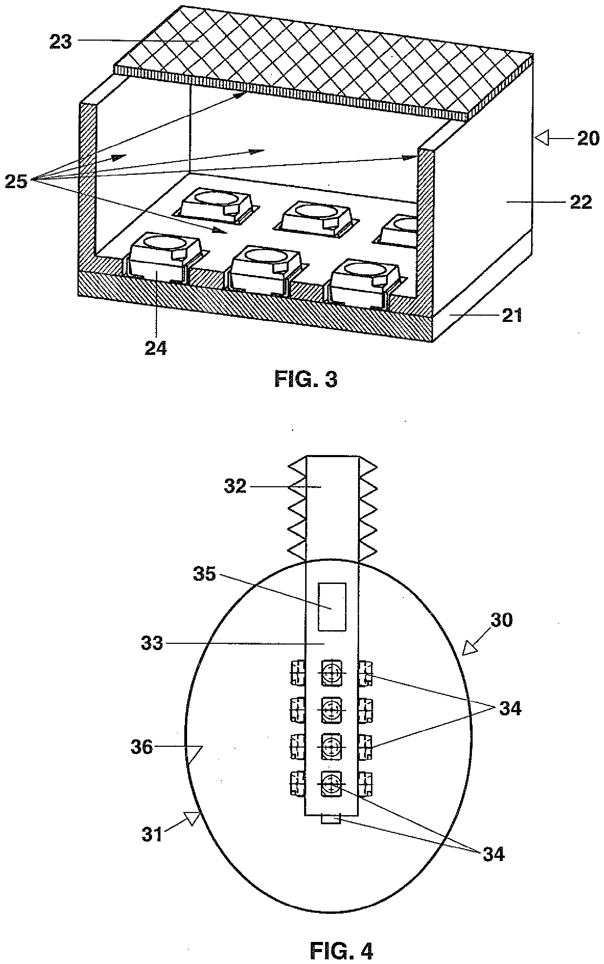

In Figur 3 ist ein Ausschnitt aus einer Flächenleuchte 20 gezeigt. Sie besteht aus einem gemeinsamen Träger 21, auf den ein quaderförmiges äußeres Gehäuse 22 aufgeklebt ist. Seine Oberseite ist mit einer gemeinsamen Abdeckung 23 versehen. Das quaderförmige Gehäuse besitzt Aussparungen, in denen einzelne Halbleiter-Bauelemente 24 untergebracht sind. Sie sind UV-emittierende Leuchtdioden. Die Umwandlung in weißes Licht erfolgt mittels Konversionsschichten 25, die auf allen der UV-Strahlung zugänglichen Flächen angebracht ist. Dazu zählen die innen liegenden Oberflächen der Seitenwände des Gehäuses, der Abdeckung und des Bodenteils. Die einzelnen Pixel sind ähnlich wie in Figur 2 dargestellt aufgebaut.

Ein Beispiel einer nicht erfindungsgemäßen, Kompaktlampe 30 auf der Basis von Leuchtdioden ist in Figur 4 dargestellt. Sie ähnelt äußerlich bekannten Lampen, in dem als äußeres Gehäuse ein kugeliger Außenkolben 31 auf einem Schraubsockel 32 sitzt. Der Sockel 32 trägt einen Rundstab 33, der sich weit in den Außenkolben 31 hinein erstreckt. Der Rundstab 33 bildet einen Träger, der auf seiner Oberfläche mit Leuchtdioden 34 bestückt ist. Im Inneren des Rundstabs 33 ist die Elektronik 35 verborgen. Der Außenkolben 31 ist innen mit einer Konversionsschicht 36 bedeckt. Die Leuchtdioden emittieren beispielsweise UV oder blaues Licht.

## Patentansprüche

1. Optoelektronisches Modul mit:
- einer Grundbaueinheit, die weißes Licht aussendet, das aus von einem Halbleiter-Chip emittierter UV-Strahlung im Bereich 320 nm bis 400 nm mittels Lumineszenzkonversion erzeugt wird, und
- zumindest einer weiteren Komponente, die rote und/oder blaue Anteile zur Erhöhung bzw. Erniedrigung der Farbtemperatur zumischt, wobei die Grundbaueinheit und die weiteren einzelnen Komponenten von einem Multichipgehäuse (22) umfasst sind und die Differenz zwischen den thermischen Ausdehnungskoeffizienten der einzelnen Teile des Multichipgehäuses (22) nicht größer ist als +/-15 %, so dass alle eingesetzten Gehäusematerialien im Temperaturbereich, der in Herstellung und Anwendung auftritt, aneinander angepasste thermische Ausdehnungskoeffizienten aufweisen,
wobei das Multichipgehäuse (22) aus einem Grundkörper mit einer Ausnehmung und aus einer Abdeckung (23) je aus Glas oder Quarzglas oder Keramik oder Glaskeramik und aus einem Leiterrahmen aus Kupfer-Manteldraht gebildet ist, und wobei der Grundkörper an dem Leiterrahmen gasdicht befestigt ist, der Halbleiter-Chip in der Ausnehmung auf dem Leiterrahmen befestigt ist und die Ausnehmung mit der Abdeckung gasdicht verschlossen ist.

## Claims

1. An optoelectronic module comprising:
- a basic unit which emits white light, which is generated by means of luminescence conversion from UV radiation emitted by a semiconductor chip in the range of 320 nm to 400 nm, and
- at least one further component which mixes red and/or blue parts to increase or reduce the color temperature, wherein the basic unit and the further individual components are included by a multi-chip housing (22) and the difference between the coefficients of thermal expansion of the individual constituents of the multi-chip housing (22) is not greater than +/-15%, so that all the housing materials used have thermal expansion coefficients which are adapted to one another in the temperature range which occurs in production and use,
wherein the multi-chip housing (22) is formed from a base body having a recess and a cover (23), each formed from glass or quartz glass or ceramic or glass ceramic, and is formed from a lead frame made of copper cladding wire, and
wherein the base body is fastened to the lead frame in a gastight manner, the semiconductor chip is fastened in the recess on the lead frame and the recess is closed in a gastight manner by means of the cover.

## Revendications

1. Module optoélectronique avec :
- un module de base qui émet une lumière blanche qui est générée á partir d'un rayonnement UV émis par une puce semi-conductrice dans une plage allant de 320 à 400 nm au moyen d'une conversion par luminescence, et
- au moins un autre composant qui mélange des parts rouges et/ou bleues pour augmenter voire diminuer la température de la couleur, le module de base et les autres composants individuels étant entourés d'un boîtier multipuce (22) et la différence entre les coefficients de dilatation thermiques de chacune des pièces du boîtier multipuce (22) n'est pas supérieure à +/- 15 %, de sorte que tous les matériaux de boîtier utilisés comportent, dans la plage de température qui se produite lors de la fabrication et de l'utilisation, des coefficients de dilatation thermiques ajustés les uns aux autres,
le boîtier multipuce (22) étant constitué d'un corps de base avec un évidement et un couvercle (23), chacun étant en verre ou en verre de quartz ou en céramique ou en vitrocéramique, et d'un cadre conducteur composé d'une gaine en cuivre, et le corps principal étant fixé de manière étanche au gaz sur le cadre conducteur, la puce semi-conductrice étant fixée dans l'évidement sur le cadre conducteur et l'évidement étant fermé de manière étanche au gaz avec le couvercle.
